# EUROPEAN PATENT APPLICATION

(11) **EP 4 711 844 A1**
(43) Date of publication of application: **18.03.2026**
(21) Application number: 24832180.4
(22) Date of filing: 22.03.2024
(51) Int. Cl.: G03B 15/05, G03B 30/00, H04N 23/56, H04N 23/57, H10H 20/855, H10H 20/85, H01L 25/075

(54) **ELECTRONIC DEVICE COMPRISING OPTICAL MODULE**

(30) Priority: 27.06.2023 KR 20230082733; 27.07.2023 KR 20230098292; 20.03.2024 KR 20240038348
(71) Applicant: Samsung Electronics Co., Ltd., Suwon-si, Gyeonggi-do 16677 (KR)
(72) Inventor: KIM, Sungwon, Suwon-si Gyeonggi-do 16677 (KR); SEO, Jungpa, Suwon-si Gyeonggi-do 16677 (KR); HONG, Hyeonseok, Suwon-si Gyeonggi-do 16677 (KR); SHIM, Jaekyu, Suwon-si Gyeonggi-do 16677 (KR)
(74) Representative: HGF
(86) International application number: PCT/KR2024/003593
(87) International publication number: WO 2025/005393

(57) **Abstract**

The electronic device may include a camera module and an optical module. The optical module may comprise: a substrate; a plurality of light-emitting elements disposed on the substrate; and a first light-receiving element disposed on the substrate and configured to operate independently from the plurality of light-emitting elements.

## Description

### TECHNICAL FIELD

The disclosure generally relates to an electronic device including an optical module, for example, an electronic device including an optical module including a light-emitting element and a light-receiving element.

### BACKGROUND ART

An optical module, which may be referred to as a flash or strobe, may include a light-emitting element, such as a light-emitting diode (LED), configured to illuminate a space outside the light-emitting element. Electronic devices including one or more camera modules and optical modules are being developed to support various photographing environments or conditions. The above description has been possessed or acquired by the inventor(s) in the course of conceiving the present disclosure and is not necessarily an art publicly known before the present application is filed.

### DISCLOSURE OF THE INVENTION

### TECHNICAL SOLUTIONS

An electronic device may include a camera module and an optical module. The optical module may include a substrate, a plurality of light-emitting elements disposed on the substrate, and a first light-receiving element disposed on the substrate and configured to operate independently from the plurality of light-emitting elements.

### BRIEF DESCRIPTION OF THE DRAWINGS

The above and other aspects, features and advantages of certain embodiments of the present disclosure will be more apparent from the following detailed description, taken in conjunction with the accompanying drawings, in which:
FIG. 1 is a block diagram illustrating an electronic device in a network environment according to an embodiment.
FIG. 2 is a block diagram illustrating a camera module according to an embodiment.
FIG. 3 is a perspective view of an electronic device in one direction according to an embodiment.
FIG. 4 is a perspective view of the electronic device in another direction according to an embodiment.
FIG. 5 is a plan view of an optical module according to an embodiment.
FIG. 6 is a cross-sectional view of the optical module of FIG. 5, taken along a line 6-6.
FIG. 7 is a plan view of an optical module with optical elements removed according to an embodiment.
FIG. 8 is a cross-sectional view of the light-emitting element of FIG. 7, taken along a line 8-8.
FIG. 9 is a cross-sectional view of the light-receiving element of FIG. 7, taken along a line 9-9.
FIG. 10 is a block diagram of an electronic device according to an embodiment.
FIG. 11 is a block diagram of an electronic device according to an embodiment.
FIG. 12 is a block diagram of an electronic device according to an embodiment.
FIG. 13 is a diagram illustrating an optical module according to an embodiment.
FIG. 14 is a diagram illustrating an optical module according to an embodiment.
FIG. 15 is a diagram illustrating an optical module according to an embodiment.
FIG. 16 is a plan view of an optical module according to an embodiment.

### MODE FOR CARRYING OUT THE INVENTION

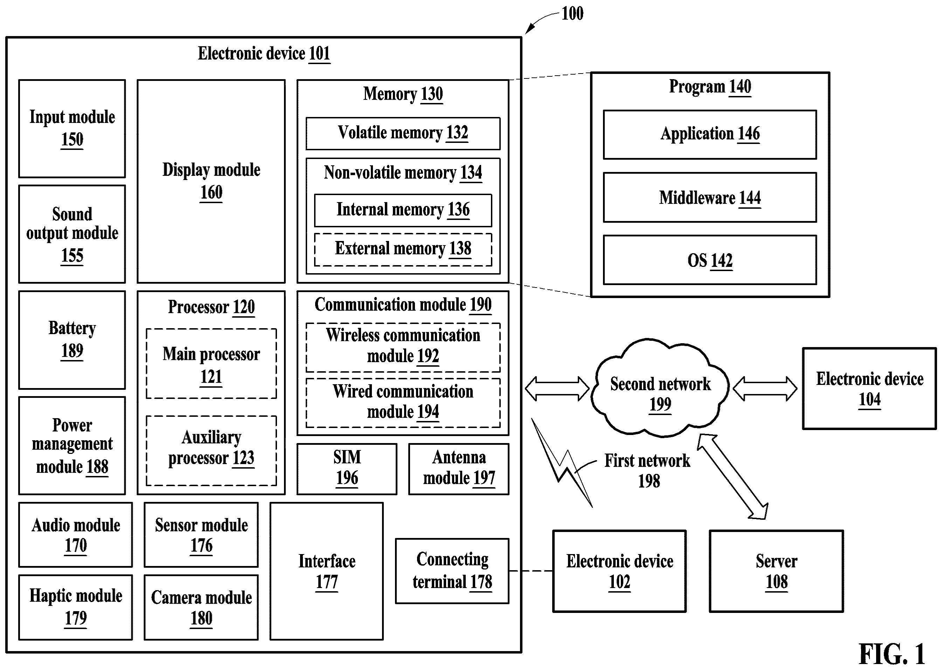

FIG. 1 is a block diagram illustrating an electronic device in a network environment according to an embodiment.

Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added to the electronic device 101. In some embodiments, some of the components (e.g., the sensor module 176, the camera module 180, or the antenna module 197) may be implemented as a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to an embodiment, as at least part of data the processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently from, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state or together with the main processor 121 while the main processor 121 is in an active state (e.g., executing an application). According to an embodiment, the auxiliary processor 123 (e.g., an ISP or a CP) may be implemented as part of another component (e.g., the camera module 180 or the communication module 190) functionally related to the auxiliary processor 123. According to an embodiment, the auxiliary processor 123 (e.g., an NPU) may include a hardware structure specified for artificial intelligence model processing. An artificial intelligence model may be generated by machine learning. Such learning may be performed, e.g., by the electronic device 101 where the artificial intelligence model is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., the electronic device 102) (e.g., a speaker or headphone) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, ISPs, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., the AP) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide region network (WAN)). These various types of communication modules may be implemented as a single component (e.g., a single chip), or may be implemented as multiple components (e.g., multiple chips) separate from each other. The wireless communication module 192 may identify or authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a PCB, an RFIC disposed on a first surface (e.g., the bottom surface) of the PCB or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an Internet-of-Things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to the embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. According to an embodiment of the disclosure, the electronic devices are not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms such as "1^{st}," and "2^{nd}," or "first" and "second" may be used to simply distinguish a corresponding component from another, and do not limit the components in other aspect (e.g., importance or order). It is to be understood that if an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or via a third element.

As used in connection with embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to embodiments disclosed herein may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

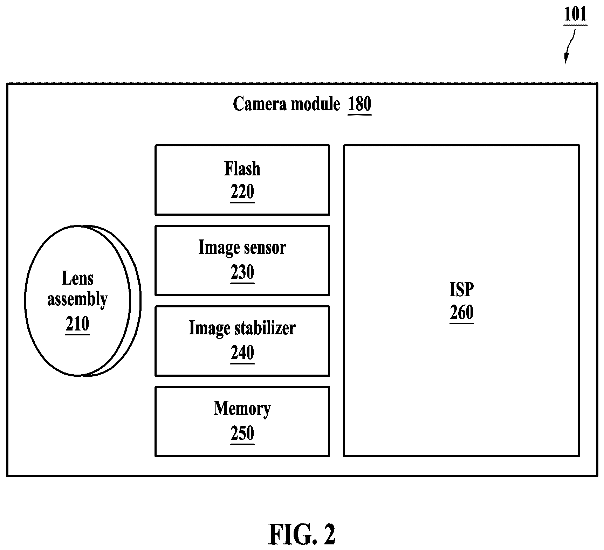

FIG. 2 is a block diagram illustrating a camera module according to an embodiment.

Referring to FIG. 2, the camera module 180 may include a lens assembly 210, a flash 220, an image sensor 230, an image stabilizer 240, memory 250 (e.g., buffer memory), or an ISP 260. The lens assembly 210 may collect light emitted from an object whose image is to be taken. The lens assembly 210 may include one or more lenses. According to an embodiment, the camera module 180 may include a plurality of lens assemblies 210. In such a case, the camera module 180 may form, for example, a dual camera, a 360-degree camera, or a spherical camera. Some of the plurality of lens assemblies 210 may have the same lens attribute (e.g., view angle, focal length, auto-focusing, f number, or optical zoom), or at least one lens assembly may have one or more lens attributes different from those of another lens assembly. The lens assembly 210 may include, for example, a wide-angle lens or a telephoto lens.

The flash 220 may emit light that is used to reinforce light emitted or reflected from an object. According to an embodiment, the flash 220 may include one or more light emitting diodes (LEDs) (e.g., a red-green-blue (RGB) LED, a white LED, an IR LED, or an ultraviolet (UV) LED) or a xenon lamp. The image sensor 230 may obtain an image corresponding to an object by converting light emitted or reflected from the object and transmitted via the lens assembly 210 into an electrical signal. According to an embodiment, the image sensor 230 may include, for example, one selected from image sensors having different attributes, such as, for example, an RGB sensor, a black-and-white (BW) sensor, an IR sensor, or a UV sensor, a plurality of image sensors having the same attribute, or a plurality of image sensors having different attributes. Each image sensor included in the image sensor 230 may be implemented using, for example, a charged coupled device (CCD) sensor or a complementary metal oxide semiconductor (CMOS) sensor.

The image stabilizer 240 may move the image sensor 230 or at least one lens included in the lens assembly 210 in a particular direction, or control an operational attribute (e.g., adjust the read-out timing) of the image sensor 230 in response to the movement of the camera module 180 or the electronic device 101 including the camera module 180. This allows compensating for at least part of a negative effect by the movement on an image being captured. According to an embodiment, the image stabilizer 240 may sense such a movement by the camera module 180 or the electronic device 101 using a gyro sensor (not shown) or an acceleration sensor (not shown) disposed inside or outside the camera module 180. According to an embodiment, the image stabilizer 240 may be implemented, for example, as an optical image stabilizer. The memory 250 may store, at least temporarily, at least part of an image obtained via the image sensor 230 for a subsequent image processing task. For example, if image capturing is delayed due to shutter lag or multiple images are quickly captured, a raw image obtained (e.g., a Bayer-patterned image, a high-resolution image) may be stored in the memory 250, and its corresponding copy image (e.g., a low-resolution image) may be previewed via the display module 160. Thereafter, if a specified condition is met (e.g., by a user's input or system command), at least part of the raw image stored in the memory 250 may be obtained and processed, for example, by the ISP 260. According to an embodiment, the memory 250 may be configured as at least part of the memory 130 or as a separate memory that is operated independently from the memory 130.

The ISP 260 may perform one or more image processing with respect to an image obtained via the image sensor 230 or an image stored in the memory 250. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the ISP 260 may perform control (e.g., exposure time control or read-out timing control) with respect to at least one (e.g., the image sensor 230) of the components included in the camera module 180 . An image processed by the ISP 260 may be stored back in the memory 250 for further processing, or may be provided to an external component (e.g., the memory 130, the display module 160, the electronic device 102, the electronic device 104, or the server 108) outside the camera module 180. According to an embodiment, the ISP 260 may be configured as at least part of the processor 120, or as a separate processor operated independently from the processor 120. If the ISP 260 is configured as a separate processor from the processor 120, at least one image processed by the ISP 260 may be displayed, by the processor 120, via the display module 160 as it is or after being further processed.

According to an embodiment, the electronic device 101 may include a plurality of camera modules 180 having different attributes or functions. In such a case, at least one of the plurality of camera modules 180 may form, for example, a wide-angle camera and at least another of the plurality of camera modules 180 may form a telephoto camera. Similarly, at least one of the plurality of camera modules 180 may form, for example, a front camera and at least another of the plurality of camera modules 180 may form a rear camera.

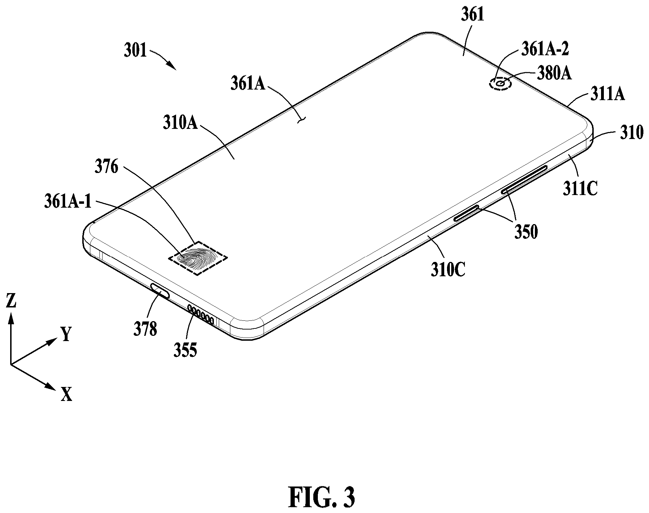

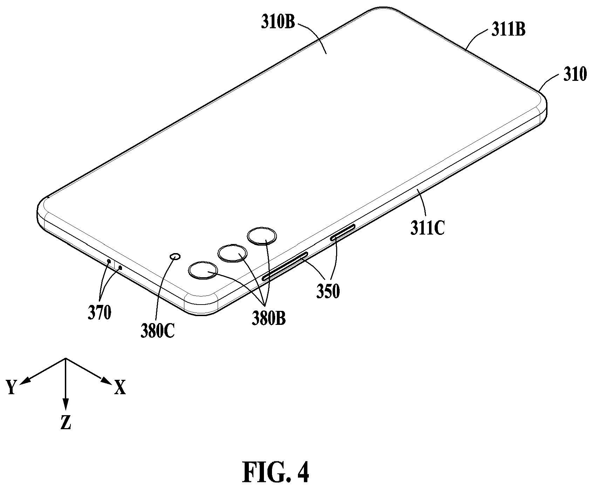

FIG. 3 is a perspective view of an electronic device in one direction according to an embodiment. FIG. 4 is a perspective view of the electronic device in another direction according to an embodiment.

Referring to FIGS. 3 and 4, an electronic device 301 (e.g., the electronic device 101 of FIG. 1) may include a housing 310 including a first surface 310A (e.g., a front surface), a second surface 310B (e.g., a rear surface), and a third surface 310C (e.g., a side surface) enclosing a space between the first surface 310A and the second surface 310B. The first surface 310A may be formed by a first plate 311A of which at least a portion is substantially transparent. For example, the first plate 311A may include a polymer plate or a glass plate including at least one coating layer. The second surface 310B may be formed by a second plate 311B that is substantially opaque. For example, the second plate 311B may be formed of coated or tinted glass, ceramic, polymer, metal (e.g., aluminum, stainless steel (STS), or magnesium), or a combination thereof. The third surface 310C may be formed by a frame 311C that is coupled to the first plate 311A and the second plate 311B and includes a metal and/or a polymer. The second plate 311B and the frame 311C may be formed monolithically. The second plate 311B and the frame 311C may be formed of substantially the same material (e.g., aluminum).

The electronic device 301 may include an input module 350 (e.g., the input module 150 of FIG. 1). The input module 350 may be disposed on the third surface 310C. The input module 350 may include at least one key input device. For example, the key input device may include one or more mechanical actuators (e.g., buttons), one or more capacitors, and/or one or more inductors.

The electronic device 301 may include a sound output module 355 (e.g., the sound output module 155 of FIG. 1). The sound output module 355 may be disposed on the third surface 310C. The sound output module 355 may include one or more holes.

The electronic device 301 may include a display module 361 (e.g., the display module 160 of FIG. 1). The display module 361 may be disposed on the first surface 310A. The display module 361 may be visible through at least a portion of the first plate 311A. The display module 361 may have a shape that is substantially the same as the shape of an outer edge of the first plate 311A. The periphery of the display module 361 may substantially coincide with the outer edge of the first plate 311A. The display module 361 may include a touch sensing circuit, a pressure sensor for measuring an intensity (pressure) of a touch, and/or a digitizer for detecting a magnetic-type stylus pen. The display module 361 may include a screen display area 361A that is visible to display content using pixels. The screen display area 361A may include a sensing area 361A-1. The sensing area 361A-1 may overlap at least one area of the screen display area 361A. The sensing area 361A-1 may allow transmission of an input signal related to a sensor module 376 (e.g., the sensor module 176 of FIG. 1). The sensing area 361A-1 may display content, like the screen display area 361A that does not overlap the sensing area 361A-1. For example, the sensing area 361A-1 may display the content while the sensor module 376 is not operating. At least a portion of a camera area 361A-2 may overlap the screen display area 361A. The screen display area 361A may include the camera area 361A-2. The camera area 361A-2 may allow transmission of an optical signal related to a first camera module 380A (e.g., the camera module 180 of FIG. 1 and/or the camera module 180 of FIG. 2). At least a portion of the camera area 361A-2, that overlaps the screen display area 361A, may display content, similarly to the screen display area 361A that does not overlap the camera area 361A-2. For example, the camera area 361A-2 may display the content while the first camera module 380A is not operating.

The electronic device 301 may include an audio module 370 (e.g., the audio module 170 of FIG. 1). The audio module 370 may be disposed on the third surface 310C. The audio module 370 may obtain a sound through at least one hole.

The electronic device 301 may include the sensor module 376. The sensor module 376 may be disposed on the first surface 310A. The sensor module 376 may form the sensing area 361A-1 in at least a portion of the screen display area 361A. The sensor module 376 may receive an input signal transmitted through the sensing area 361A-1 and generate an electrical signal based on the received input signal. For example, the input signal may have a designated physical quantity (e.g., heat, light, temperature, sound, pressure, or ultrasound). The input signal may include a signal related to biometric information (e.g., a fingerprint) of a user.

The electronic device 301 may include a connecting terminal 378 (e.g., the connecting terminal 178 of FIG. 1). The connecting terminal 378 may be disposed on the third surface 310C. For example, when the electronic device 301 is viewed in one direction (e.g., the +Y direction), the connecting terminal 378 may be positioned substantially in a central portion of the third surface 310C, and the sound output module 355 may be positioned on one side (e.g., the right side) with respect to the connecting terminal 378.

The electronic device 301 may include the first camera module 380A (e.g., the camera module 180 of FIG. 1 and/or the camera module 180 of FIG. 2). The first camera module 380A may be disposed on the first surface 310A. At least a portion of the first camera module 380A may be disposed under the display module 361. The first camera module 380A may receive an optical signal transmitted through the camera area 361A-2.

The electronic device 301 may include a plurality of second camera modules 380B (e.g., the camera module 180 of FIG. 1 and/or the camera module 180 of FIG. 2). The plurality of second camera modules 380B may be disposed on the second surface 310B. The plurality of second camera modules 380B may be arranged in one direction (e.g., the Y direction) of the second plate 311B. The plurality of second camera modules 380B may have different fields of view. For example, the plurality of second camera modules 380B may include an ultra wide-angle camera, a wide-angle camera, and/or a telephoto camera.

The electronic device 301 may include an optical module 380C (e.g., the flash 220 of FIG. 2). The optical module 380C may be disposed on the second surface 310B. The optical module 380C may include one or more light-emitting diodes or xenon lamps. The optical module 380C may include a sensor configured to detect external light. For example, the sensor may include a flicker sensor.

Meanwhile, the embodiments set forth herein may also apply to electronic devices of various shapes/forms (e.g., a foldable electronic device, a slidable electronic device, a rollable electronic device, a digital camera, a digital video camera, a tablet personal computer (PC), a laptop computer, and other electronic devices), in addition to the electronic device shown in FIGS. 3 and 4.

As used herein, the terms "substantially", "approximately", "generally", and "about" in reference to a given parameter, attribute, or condition may include a degree that one of ordinary skill in the art would understand that the given parameter, attribute, or condition is met with a small degree of variance, such as within acceptable manufacturing tolerances. For example, a parameter that is substantially met may be at least about 90% met, at least about 95% met, or at least about 99% met.

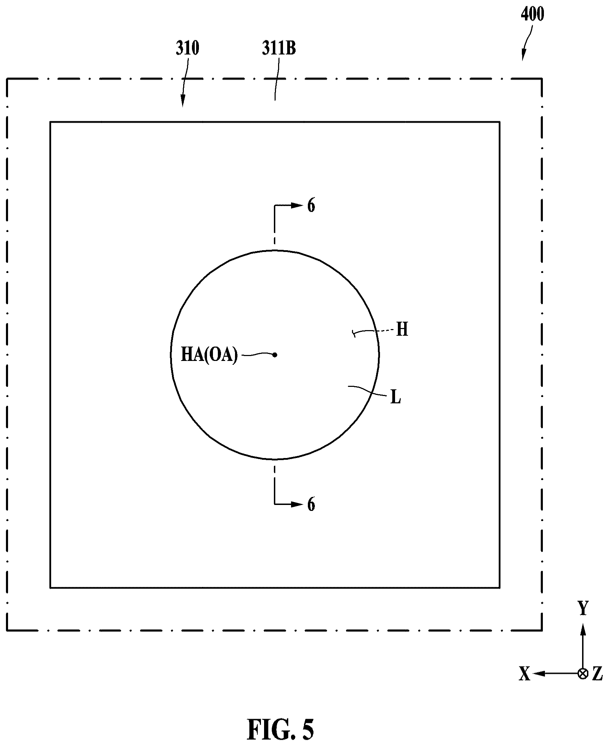

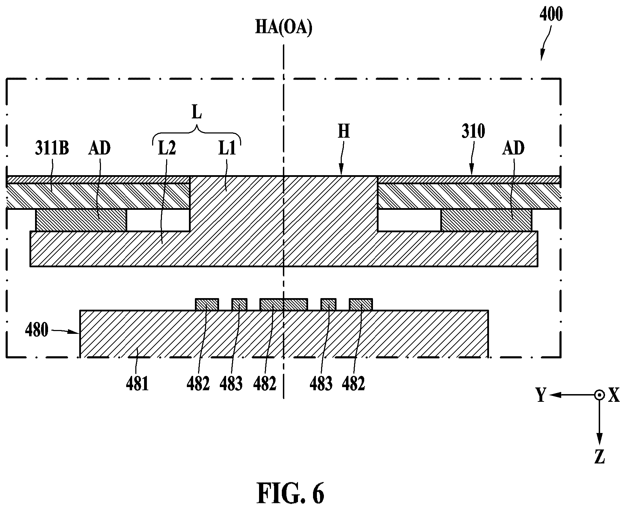

FIG. 5 is a plan view of an optical module according to an embodiment. FIG. 6 is a cross-sectional view of the optical module of FIG. 5, taken along a line 6-6.

Referring to FIGS. 5 and 6, an electronic device 400 (e.g., the electronic device 101 of FIG. 1, the electronic device 101 of FIG. 2, and/or the electronic device 301 of FIGS. 3 and 4) may include the housing 310. The housing 310 may include a hole H. The hole H may be circular or oval. In an example not shown, the hole H may be a polygon. The hole H may penetrate the second plate 311B from a first side (e.g., a -Z direction side) to a second side (e.g., a +Z direction side), of the second plate 311B. In an embodiment not shown, the hole H may be included in an optical module 480. For example, the optical module 480 may include a plate (not shown) configured to be coupled (e.g., assembled) to the second plate 311B, and a hole H disposed in the plate.

The electronic device 400 may include the optical module 480 (e.g., the optical module 380C of FIGS. 3 and 4). The optical module 480 may be disposed inside the housing 310. The optical module 480 may be disposed to face the second plate 311B. In an embodiment not shown, the optical module 480 may be disposed to face a first plate (not shown) (e.g., the first plate 311A of FIGS. 3 and 4) opposite the second plate 311B.

The optical module 480 may include a substrate 481. The substrate 481 may be referred to as a "PCB" or a "flexible PCB (FPCB)." The substrate 481 may include electrical circuitry for one or more elements (e.g., a light-emitting element 482 and/or light-receiving element 483) disposed on the substrate 481. The substrate 481 may include a surface (e.g., a -Z direction surface) facing the hole H.

The optical module 480 may include one or more light-emitting elements 482. The one or more light-emitting elements 482 may be configured to illuminate light of a particular wavelength band. For example, the light-emitting element 482 may include an LED. The particular wavelength band may be an IR band or visible band. The one or more light-emitting elements 482 may be disposed on a surface (e.g., the -Z direction surface) of the substrate 481 facing the hole H.

The optical module 480 may include one or more light-receiving elements 483. The one or more light-receiving elements 483 may be configured to receive light (e.g., ambient light) from a space in which the electronic device 400 is placed. For example, the light-receiving element 483 may include a photodiode.

The light-emitting element 482 may be configured to be driven independently from the light-receiving element 483. Here, "driven independently" may refer to an operation of the light-emitting element 482 and an operation of the light-receiving element 483 not substantially affecting each other. For example, when the light-emitting element 482 is in an active state (e.g., ON state), the light-receiving element 483 may remain in an inactive state (e.g., OFF state). Conversely, when the light-emitting element 482 is in an inactive state (e.g., OFF state), the light-receiving element 483 may be in an active state (e.g., ON state). Light emitted from the light-emitting element 482 may not directly enter the light-receiving element 483.

A plurality of light-emitting elements 482 may be configured to operate substantially simultaneously. For example, the plurality of light-emitting elements 482 may have substantially the same duty cycle.

The number of light-emitting elements 482 may be significantly greater than the number of light-receiving elements 483. Here, "substantially greater" may refer to the number of light-emitting elements 482 being at least three times, at least four times, at least five times, at least six times, at least seven times, at least eight times or more than the number of light-receiving elements 483. An area occupied by the plurality of light-emitting elements 482 on the substrate 481 may be greater than an area occupied by one or more light-receiving elements 483 on the substrate 481. Increasing the number of light-emitting elements 482 compared to the number of light-receiving elements 483 may not substantially increase the size of the optical module 480. This may increase the degree of design freedom of the plurality of light-emitting elements 482 and one or more light-receiving elements 483.

The electronic device 400 may include a lens L. In the disclosure, the lens L may be referred to as an "optical element." The lens L may provide a required field of view (FOV) to one or more light-emitting elements 482 and one or more light-receiving elements 483. For example, the lens L may include a Fresnel lens. However, the shape and/or type of the lens L is not limited thereto, and lenses of various shapes and/or types may be implemented. An optical element, such as the lens L, may provide light distribution of the one or more light-emitting elements 482.

The lens L may have an optical axis OA (e.g., Z-axis). The optical axis OA may be defined as an extended line connecting the center of curvature of a first surface (e.g., a +Z direction surface of a lens body L1) of the lens L and the center of curvature of a second surface (e.g., a -Z direction surface of the lens body L1) of the lens L opposite the first surface.

The lens L may include the lens body L1. The lens body L1 may be configured to fit into the hole H. For example, the lens body L1 may be configured to be substantially aligned with the optical axis OA and a hole axis HA (e.g., the Z-axis). The lens body L1 may extend within the hole H and beyond the hole H into the inside of the housing 310.

The lens L may include a lens flange L2. The lens flange L2 may extend in a radial direction from the lens body L1. The lens flange L2 may be disposed inside the housing 310. The lens flange L2 may be spaced apart from the second plate 311B by a gap. The lens flange L2 may be attached to the second plate 311B via one or more suitable adhesives AD.

In an embodiment not shown, the electronic device 400 may not include the lens L. For example, light emitted from the one or more light-emitting elements 482 may escape outside the housing 310 without an optical system. Light outside the housing 310 (e.g., ambient light) may enter the one or more light-receiving elements 483 without an optical system.

In an embodiment not shown, the lens L may be formed integrally with the optical module 480. In an embodiment not shown, the lens L may be a separate component from the optical module 480.

In an embodiment not shown, the electronic device 400 may include a reflector (not shown) which may be referred to as an "optical element." A reflector may be disposed between the optical module 480 and the hole H. The reflector may be formed integrally with the optical module 480. The reflector may be a separate component from the optical module 480.

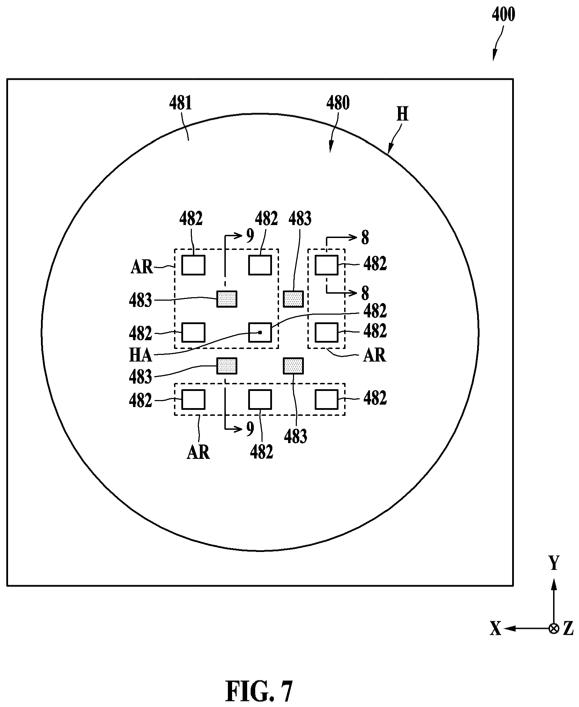

FIG. 7 is a plan view of an optical module with optical elements removed according to an embodiment.

Referring to FIG. 7, the optical module 480 may include a plurality of light-emitting elements 482. For example, the number of light-emitting elements 482 is shown as 9, but embodiments are not limited thereto. The optical module 480 including the plurality of light-emitting elements 482 may allow adjustment of a light-emitting area and implementation of a light source suitable for various conditions.

The plurality of light-emitting elements 482 may form an array. The plurality of light-emitting elements 482 may be arranged in a first direction (e.g., +/-X direction) of the substrate 481 and in a second direction (e.g., +/-Y direction) of the substrate 481 that is different from the first direction. The first direction and the second direction may be substantially orthogonal to each other.

The array of the plurality of light-emitting elements 482 may be in the form of an N x M matrix. Here, N and M may be natural numbers greater than or equal to 1, N may be the number of light-emitting elements 482 in the first direction (e.g., +/-X direction) of the substrate 481, and M may be the number of light-emitting elements 482 in the second direction (e.g., +/-Y direction) of the substrate 481. In a non-limiting example, the array may be in the form of a 3 x 3 matrix.

The plurality of light emitting elements 482 may be configured to be driven by particular areas AR. In a non-limiting example, the array may be divided into an area AR in the form of a 2 x 2 matrix, an area AR in the form of a 3 x 1 matrix, and an area AR in the form of a 1 x 2 matrix. The brightness of light emitted by one or more light-emitting elements 482 arranged in one area AR may be different from the brightness of light emitted by one or more light-emitting elements 482 arranged in another area AR.

The plurality of light-emitting elements 482 may have various combinations of optical properties. In an example, an illumination angle of one light-emitting element 482 may be different from an illumination angle of another light-emitting element 482. In an example, a wavelength band of light emitted by one light-emitting element 482 may be different from a wavelength band of light emitted by another light-emitting element 482.

The plurality of light-emitting elements 482 may be arranged symmetrically. For example, the plurality of light-emitting elements 482 may be symmetrical with respect to the first direction (e.g., +/-X direction) of the substrate 481. The plurality of light-emitting elements 482 may be symmetrical with respect to the second direction (e.g., +/-Y direction) of the substrate 481. The plurality of light-emitting elements 482 may be point-symmetrical about a point (e.g., a center point) where the hole axis HA passes through the substrate 481. The symmetrical structure of the light-emitting elements 482 may provide natural external visibility without discomfort when viewing the inside of the electronic device 400 and/or aesthetic appeal when viewing the electronic device 400 from the outside.

The optical module 480 may include one or more (e.g., four) light-receiving elements 483. The light-receiving element 483 may be disposed on the substrate 481 on which the array of the plurality of light-emitting elements 482 is disposed. In an example, one or more light-receiving elements 483 may be disposed within an array area (e.g., an array area defined by a 3 x 3 matrix form) of the substrate 481 defined by the array of the plurality of light-emitting elements 482. In an example, one or more of the light-receiving elements 483 may not overlap with the light-emitting elements 482 when viewing the substrate 481 in one direction (e.g., the +/-X direction and/or +/-Y direction). In another example, the light-receiving element 483 may overlap a pair of adjacent light-emitting elements 482 when viewed diagonally (e.g., +/-45 degrees and/or +/-135 degrees about the hole axis HA in FIG. 7) across the substrate 481. In an example not shown, one or more light-receiving elements 483 may overlap one or more light-emitting elements 482 when viewed in one direction from the substrate 481.

One or more light-receiving elements 483 may be arranged substantially coaxially with the plurality of light-emitting elements 482. The directionality of a cone of FOV of one or more light-receiving elements 483 may be substantially coincident with or parallel to the directionality of the cone of FOV of each of the plurality of light-emitting elements 482. The plurality of light-emitting elements 482 and the one or more light-receiving elements 483 may be substantially aligned with the hole H of the electronic device 400. The plurality of light-emitting elements 482 and the one or more light-receiving elements 483 may not be substantially eccentric with respect to the hole axis HA of the hole H. This may allow the angle of light incident on the light-receiving element 483 to be constant (e.g., within a range of about 30 degrees to about 60 degrees with respect to a centerline of a cone of the light-receiving element 483) regardless of a direction in which the substrate 481 is viewed. Additionally, absolute measurements of ambient light, such as a light sensor, as well as an ability to detect ambient light, such as a flicker sensor, may be possible. Additionally, the degree of design freedom may be increased in the arrangement of the plurality of light-emitting elements 482 and the one or more light-receiving elements 483, as well as in an optical system associated therewith (e.g., an optical element such as the lens L of FIG. 6).

The one or more light-receiving elements 483 may be at a first distance from the hole axis HA, and at least some of the light-emitting elements 482 among the plurality of light-emitting elements 482 may be at a second distance from the hole axis HA, which is greater than the first distance. The one or more light-receiving elements 483 may be disposed in a central area among areas of the substrate 481 that are aligned with the hole HA. At least some of the light-emitting elements 482 may be disposed in peripheral areas outside the central area among areas of the substrate 481 that are aligned with the hole H. At least one light-emitting element 482 may be disposed on the hole axis HA. In an embodiment not shown, the one or more light-receiving elements 483 may be disposed on the hole axis HA.

A plurality of (e.g., four) light-receiving elements 483 may be arranged symmetrically. For example, the plurality of light-receiving elements 483 may be symmetrical with respect to the first direction (e.g., +/-X direction) of the substrate 481. The plurality of light-receiving elements 483 may be symmetrical with respect to the second direction (e.g., +/-Y direction) of the substrate 481. The plurality of light-receiving elements 483 may be point-symmetrical about a point (e.g., a center point) where the hole axis HA passes through the substrate 481. The symmetrical structure of the light-receiving elements 483 may provide natural external visibility without discomfort when viewing the inside of the electronic device 400 and/or aesthetic appeal when viewing the electronic device 400 from the outside.

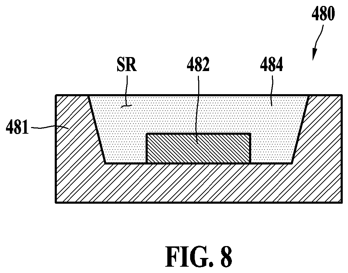

FIG. 8 is a cross-sectional view of the light-emitting element of FIG. 7, taken along a line 8-8.

Referring to FIG. 8, the optical module 480 may include the substrate 481 including an at least partially formed recess SR. The optical module 480 may include the light-emitting element 482. The light-emitting element 482 may be disposed in the recess SR. In an embodiment not shown, the light-emitting element 482 may be disposed in an area of the substrate 481 where the recess SR is not formed. The optical module 480 may include a phosphor 484 disposed on the light-emitting element 482. The phosphor 484 may be configured to emit light in a visible band by absorbing light in the corresponding band when exposed to light in a particular band (e.g., a band near ultraviolet ray in the visible band or ultraviolet band, which may be referred to as a "deep blue band") of light illuminated by the light-emitting element 482. For example, the phosphor 484 may be made of cerium-doped yttrium aluminum garnet (YAG:Ce) crystals in powder form. The phosphor 484 may substantially surround the entire light-emitting element 482. The recess SR may be filled with the phosphor 484.

In an embodiment not shown, the optical module 480 may include an optical element (not shown) disposed on the light-emitting element 482. For example, the optical element may include a lens or a reflector. In an embodiment, an optical element may be disposed on each individual light-emitting element 482. In an embodiment, an optical element may be disposed corresponding to one or more light-emitting elements 482 disposed in a particular area on the substrate 481. In an embodiment, an optical element may be disposed corresponding to one or more light-emitting elements 482 disposed substantially over the entire area on the substrate 481.

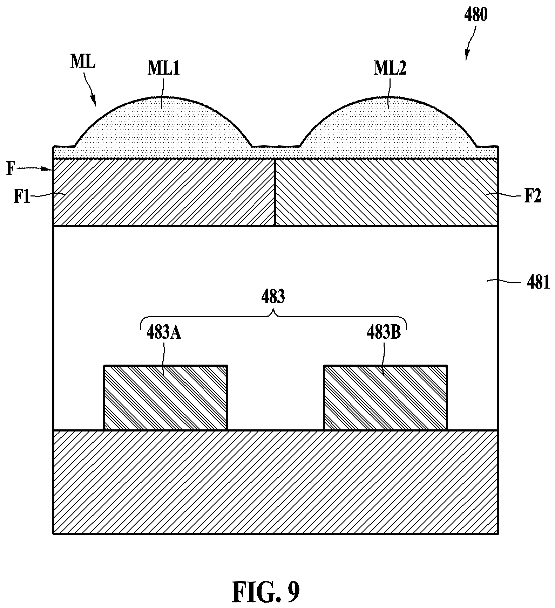

FIG. 9 is a cross-sectional view of the light-receiving element of FIG. 7, taken along a line 9-9.

Referring to FIG. 9, the optical module 480 may include one or more light-receiving elements 483 disposed on the substrate 481. For example, the optical module 480 may include a first light-receiving element 483A and a second light-receiving element 483B.

The optical module 480 may include an optical filter F configured to transform light entering one or more light-receiving elements 483 into light of a particular band. For example, the optical filter F may be implemented as an optical film. The optical filter F may include a first optical filter F1 disposed on the first light-receiving element 483A, and a second optical filter F2 disposed on the second light-receiving element 483B. The first optical filter F1 and the second optical filter F2 may have different optical characteristics. In a non-limiting example, the first optical filter F1 may transform incident light into light in a wavelength band of about 660 nm, and the second optical filter F2 may transform incident light into light in a wavelength band of about 340 nm. This may allow an amount of light to be measured at each wavelength. Light transformed by passing through the first optical filter F1 and/or the second optical filter F2 may be transmitted to the first light-receiving element 483A and/or the second light-receiving element 483B.

In an embodiment not shown, the optical filter F may be implemented as a single optical filter. In an embodiment not shown, the optical filter F may include a number of optical filters greater than the number of light-receiving elements 483. An increased number of optical filters may improve the sensitivity of the light-receiving element 483.

The optical module 480 may include one or more optical elements ML. For example, the optical element ML may include a first microlens ML1 disposed on the first optical filter F1, and a second microlens ML2 disposed on the second optical filter F2. As illustrated, the first microlens ML1 and the second microlens ML2 may be disposed corresponding to the first light-receiving element 483A and the second light-receiving element 483B. In an embodiment not shown, the optical elements ML may be disposed corresponding to one or more light-receiving elements 483 arranged in a particular area on the substrate 481. In an embodiment not shown, the optical elements ML may be disposed corresponding to one or more light-receiving elements 483 arranged substantially over the entire area on the substrate 481. In an embodiment not shown, the optical element ML may include a reflector.

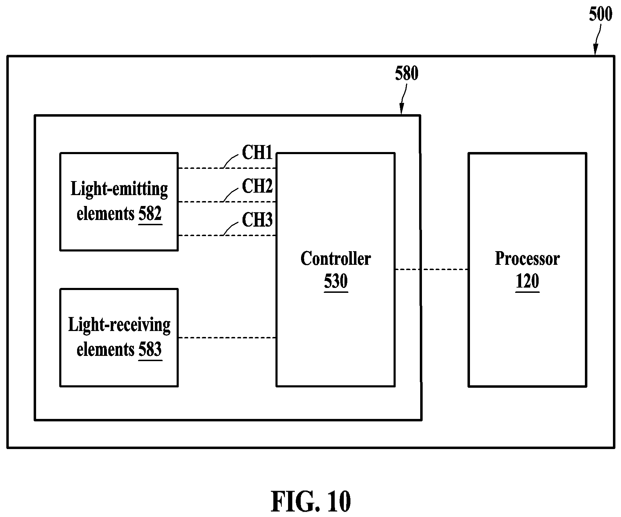

FIG. 10 is a block diagram of an electronic device according to an embodiment.

Referring to FIG. 10, an electronic device 500 (e.g., the electronic device 101 of FIG. 1, the electronic device 101 of FIG. 2, the electronic device 301 of FIGS. 3 and 4, and/or the electronic device 400 of FIGS. 5 to 7) may include the processor 120 and an optical module 580 (e.g., the optical module 380C of FIGS. 3 and 4, and/or the optical module 480 of FIGS. 5 to 9). The optical module 580 may include one or more light-emitting elements 582 (e.g., the light-emitting elements 482 of FIGS. 5 to 8), one or more light-receiving elements 583 (e.g., the light-receiving elements 483 of FIGS. 5 to 7 and 9), and a controller 530. The controller 530 may be configured to control an operation of the one or more light-emitting elements 582 and/or an operation of the one or more light-receiving elements 583. For example, the controller 530 may include a microcontroller unit MCU.

The controller 530 may include a first channel CH1 configured to individually control a plurality of light-emitting elements 582. For example, the controller 530 may be configured to control an ON/OFF operation timing of each of the plurality of light-emitting elements 582 and/or the distribution of current to be applied to the plurality of light-emitting elements 582 via the first channel CH1.

The controller 530 may include a second channel CH2 configured to control the plurality of light-emitting elements 582 in particular areas. For example, the controller 530 may control, as shown in FIG. 7, an area AR of an array of the light-emitting elements 482 in a 2 x 2 matrix form, an area AR of an array of the light-emitting elements 482 in a 3 x 1 matrix form, and an area AR of an array of the light-emitting elements 482 in a 1 x 2 matrix form, respectively. The controller 530 may supply a first power to the light-emitting elements 482 arranged in one area AR so that the light-emitting elements 482 illuminate light of a first brightness, and supply a second power different from the first power to the light-emitting elements 482 arranged in another area AR so that the light-emitting elements 482 illuminate light of a second brightness different from the first brightness.

The controller 530 may include a third channel CH3 configured to collectively control the plurality of light-emitting elements 582. The controller 530 may be configured to control the ON/OFF operation timing or the distribution of current to be applied to the plurality of light-emitting elements 582 arranged substantially over the entire area of the array via the third channel CH3.

The controller 530 may be configured to control one or more particular light-emitting elements 582 in response to commands from the processor 120. For example, the processor 120 may transmit a command signal to the controller 530 to cause the one or more particular light-emitting elements 582 to operate at a particular brightness.

In an embodiment not shown, the controller 530 may include more channels than the number of channels shown (e.g., CH1, CH2, CH3). In an embodiment not shown, the controller 530 may control the light-emitting element 582 via a single channel.

The controller 530 may be configured to calculate various result values using electrical signals transformed by the light-receiving elements 583 from one or more light-receiving elements 583. For example, the controller 530 may be configured to perform binning, skipping, and/or weighting.

The controller 530 may be configured to receive a request from the processor 120 and obtain information (e.g., RGB values) on the one or more light-receiving elements 583. The obtained information on the light-receiving element 583 may be transmitted to the processor 120.

The one or more light-emitting elements 582 and the one or more light-receiving elements 583 may be controlled by a single stand-alone controller 530. Considering the integrated environment of the electronic device 500, it may be advantageous to use the controller 530 separately from the processor 120 to control the operation of the plurality of light-emitting elements 582 and/or light-receiving elements 583.

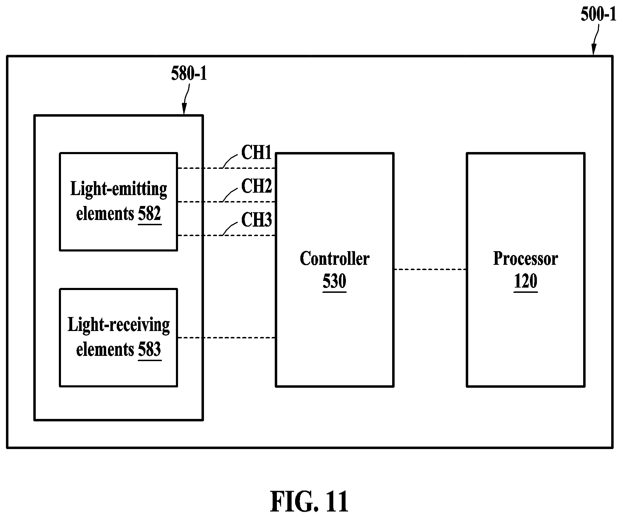

FIG. 11 is a block diagram of an electronic device according to an embodiment.

Referring to FIG. 11, an electronic device 500-1 (e.g., the electronic device 101 of FIG. 1, the electronic device 101 of FIG. 2, the electronic device 301 of FIGS. 3 and 4, the electronic device 400 of FIGS. 5 to 7, and/or the electronic device 500 of FIG. 10) may include the processor 120, an optical module 580-1 (e.g., the optical module 380C of FIGS. 3 and 4, the optical module 480 of FIGS. 5 to 9, and/or the optical module 580 of FIG. 10), and the controller 530. The optical module 580-1 may include the one or more light-emitting elements 582 and the one or more light-receiving elements 583. The controller 530 may be disposed outside the optical module 580-1. The controller 530 may be disposed in the electronic device 500-1 separately from the processor 120.

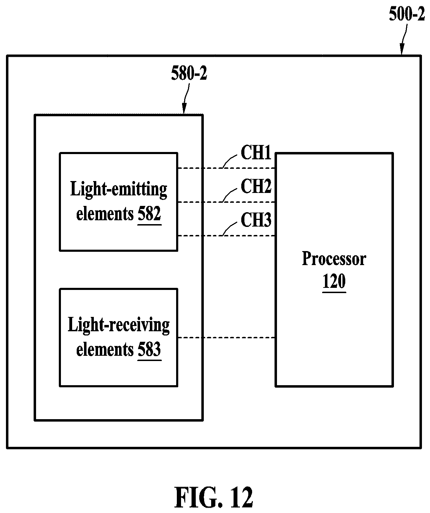

FIG. 12 is a block diagram of an electronic device according to an embodiment.

Referring to FIG. 12, an electronic device 500-2 (e.g., the electronic device 101 of FIG. 1, the electronic device 101 of FIG. 2, the electronic device 301 of FIGS. 3 and 4, the electronic device 400 of FIGS. 5 to 7, the electronic device 500 of FIG. 10, and/or the electronic device 500-1 of FIG. 11) may include the processor 120 and an optical module 580-2 (e.g., the optical module 380C of FIGS. 3 and 4, the optical module 480 of FIGS. 5 to 9, the optical module 580 of FIG. 10, and/or the optical module 580-1 of FIG. 11). The processor 120 may be configured to perform the function of the controller 530 described above with reference to FIGS. 11 and 12. The processor 120 may control the one or more light-emitting elements 582 and/or one or more light-receiving elements 583 using allocated resources without a stand-alone controller. For example, the processor 120 may cause the one or more light-emitting elements 582 to operate at a particular brightness. The processor 120 may receive information on the one or more light-receiving elements 583. The processor 120 may calculate various result values using electrical signals from the one or more light-receiving elements 583.

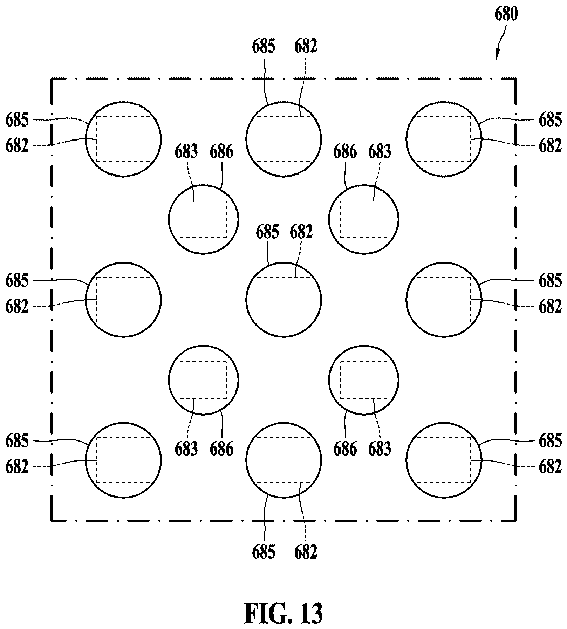

FIG. 13 is a diagram illustrating an optical module according to an embodiment.

Referring to FIG. 13, an optical module 680 (e.g., the optical module 380C of FIGS. 3 and 4, the optical module 480 of FIGS. 5 to 9, the optical module 580 of FIG. 10, the optical module 580-1 of FIG. 11, and/or the optical module 580-2 of FIG. 12) may include a plurality of light-emitting elements 682 (e.g., the light-emitting element 482 of FIGS. 5 to 8, and/or the light-emitting element 582 of FIGS. 10 to 12) and a plurality of light-receiving elements 683 (e.g., the light-receiving element 483 of FIGS. 5 to 7 and 9, and/or the light-receiving element 583 of FIGS. 10 to 12).

The optical module 680 may include a plurality of first optical elements 685 individually arranged on each of the plurality of light-emitting elements 682. For example, the plurality of first optical elements 685 may each include a lens or a reflector, or may be a combination thereof. The plurality of first optical elements 685 may each cover an area where a corresponding light-emitting element 682 is arranged. The plurality of first optical elements 685 may be arranged with respect to a corresponding light-emitting element 682. The plurality of first optical elements 685 may provide optical characteristics (e.g., FOV) required for the plurality of light-emitting elements 682.

The optical module 680 may include a plurality of second optical elements 686 individually arranged on each of the plurality of light-receiving elements 683. For example, the plurality of second optical elements 686 may each include a lens or a reflector, or may be a combination thereof. The plurality of second optical elements 686 may each cover an area where a corresponding light-receiving element 683 is arranged. The plurality of second optical elements 686 may be arranged with respect to a corresponding light-receiving element 683. The plurality of second optical elements 686 may provide optical characteristics (e.g., FOV) required for the plurality of light-receiving elements 683.

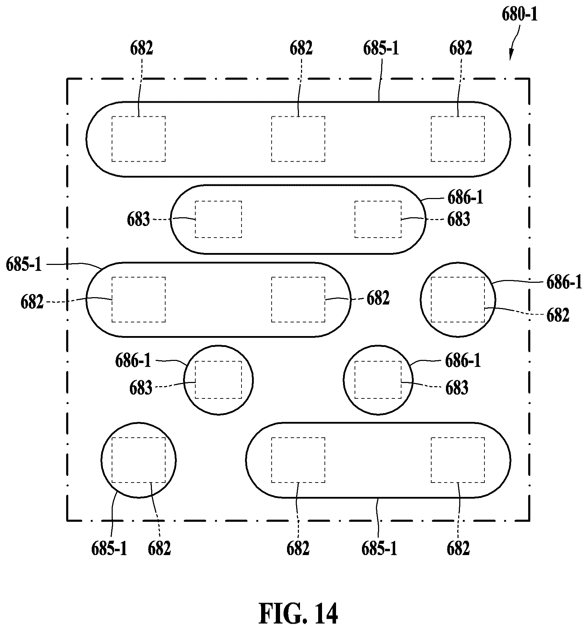

FIG. 14 is a diagram illustrating an optical module according to an embodiment.

Referring to FIG. 14, an optical module 680-1 (e.g., the optical module 380C of FIGS. 3 and 4, the optical module 480 of FIGS. 5 to 9, the optical module 580 of FIG. 10, the optical module 580-1 of FIG. 11, the optical module 580-2 of FIG. 12 and/or the optical module 680 of FIG. 13) may include the plurality of light-emitting elements 682 (e.g., the light-emitting element 482 of FIGS. 5 to 8, and/or the light-emitting element 582 of FIGS. 10 to 12) and the plurality of light-receiving elements 683 (e.g., the light-receiving element 483 of FIGS. 5 to 7 and 9, and/or the light-receiving element 583 of FIGS. 10 to 12).

The optical module 680-1 may include a plurality of first optical elements 685-1 (e.g., the first optical element 685 of FIG. 13) arranged in a plurality of areas each having one or more light-emitting elements 682. The plurality of first optical elements 685-1 may be arranged with respect to a corresponding area. In an example array of FIG. 14, one of the first optical elements 685-1 may cover three light-emitting elements 682 arranged in a row. One of the first optical elements 685-1 may cover two light-emitting elements 682 arranged in a row. One of the first optical elements 685-1 may cover a single light-emitting element 682. In an embodiment not shown, one of the first optical elements 685-1 may cover four or more light-emitting elements 682 arranged in a row. In an embodiment not shown, one of the first optical elements 685-1 may cover four or more light-emitting elements 682 in an N x M matrix form. In an embodiment not shown, one of the first optical elements 685-1 may cover a plurality of light-emitting elements 682 in an area of an arbitrary shape.

The optical module 680-1 may include a plurality of second optical elements 686-1 (e.g., the second optical element 686 of FIG. 13) arranged in a plurality of areas having one or more light-receiving elements 683. The plurality of second optical elements 686-1 may be arranged with respect to a corresponding area. In the example array of FIG. 14, one of the second optical elements 686-1 may cover two light-receiving elements 683 arranged in a row. One of the second optical elements 686-1 may cover a single light-receiving element 683. In an embodiment not shown, one of the second optical elements 686-1 may cover three or more light-receiving elements 683 arranged in a row. In an embodiment not shown, one of the second optical elements 686-1 may cover four or more light-receiving elements 683 in an N x M matrix form. In an embodiment not shown, one of the second optical elements 686-1 may cover a plurality of light-receiving elements 683 in an area of an arbitrary shape.

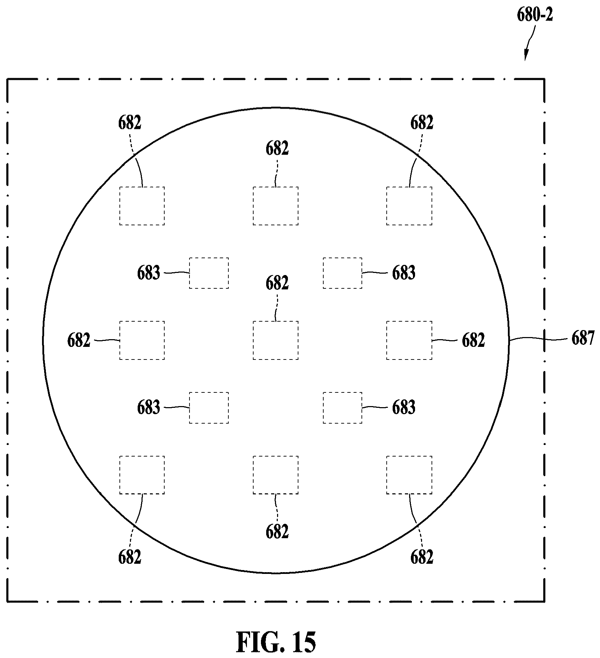

FIG. 15 is a diagram illustrating an optical module according to an embodiment.

Referring to FIG. 15, an optical module 680-2 (e.g., the optical module 380C of FIGS. 3 and 4, the optical module 480 of FIGS. 5 to 9, the optical module 580 of FIG. 10, the optical module 580-1 of FIG. 11, the optical module 580-2 of FIG. 12, the optical module 680 of FIG. 13 and/or the optical module 680-1 of FIG. 14) may include the plurality of light-emitting elements 682 (e.g., the light-emitting element 482 of FIGS. 5 to 8, and/or the light-emitting element 582 of FIGS. 10 to 12) and the plurality of light-receiving elements 683 (e.g., the light-receiving element 483 of FIGS. 5 to 7 and 9, and/or the light-receiving element 583 of FIGS. 10 to 12).

The optical module 680-2 may include an optical element 687 (e.g., the first optical element 685 of FIG. 13, the second optical element 686 of FIG. 13, the first optical element 685-1 of FIG. 14, and/or the second optical element 686-1 of FIG. 14) configured to substantially cover an entire area where the plurality of light-emitting elements 682 and the plurality of light-receiving elements 683 are disposed. For example, the optical element 687 may include a lens or a reflector. A plurality of optical elements 687 in various combinations may be arranged over the entire area.

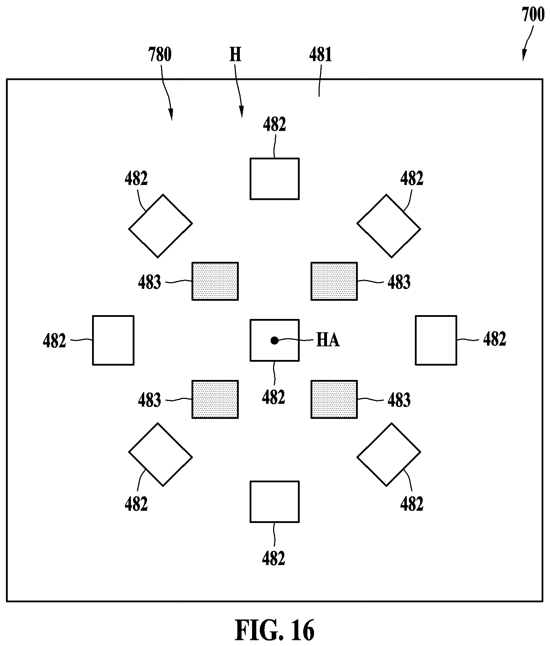

FIG. 16 is a plan view of an optical module according to an embodiment.

Referring to FIG. 16, an electronic device 700 (e.g., the electronic device 101 of FIG. 1, the electronic device 101 of FIG. 2, the electronic device 301 of FIGS. 3 and 4, the electronic device 400 of FIGS. 5 to 7, the electronic device 500 of FIG. 10, the electronic device 500-1 of FIG. 11, and/or the electronic device 500-2 of FIG. 12) may include the hole H including the hole axis HA. The electronic device 700 may include an optical module 780 (e.g., the optical module 380C of FIGS. 3 and 4, the optical module 480 of FIGS. 5 to 9, the optical module 580 of FIG. 10, the optical module 580-1 of FIG. 11, the optical module 580-2 of FIG. 12, the optical module 680 of FIG. 13, the optical module 680-1 of FIG. 14, and/or the optical module 680-2 of FIG. 15). The optical module 780 may include the substrate 481, the plurality of light-emitting elements 482, and the plurality of light-receiving elements 483.

At least two of the plurality of light-emitting elements 482 may be arranged circumferentially (e.g., in a circumferential direction) around the center of the substrate 481 (e.g., a point where the hole axis HA passes through the substrate 481). One of the light-emitting elements 482 may be disposed substantially at the center of the substrate 481.

The plurality of light-receiving elements 483 may be arranged closer to the center of the substrate 481 than at least two light-emitting elements 482 arranged circumferentially around the center of the substrate 481. A distance (e.g., a first radius) between the center of the substrate 481 and one of the light-receiving elements 483 may be less than a distance (e.g., a second radius) between the center of the substrate 481 and one of the light-emitting elements 482. As the light-emitting element 482 is further from the center of the substrate 481 (e.g., the point where the hole axis HA passes through the substrate 481) and the light-receiving element 483 is closer to the center of the substrate 481, an FOV securing performance of incident light (e.g., ambient light) required for the light-receiving element 483 may be improved. Additionally, the degree of design freedom of one or more optical elements for the optical module 780 may be increased.

One or more light-receiving elements 483 may be arranged on a virtual extension line connecting one of the light-emitting elements 482 arranged at the center of the substrate 481 and the light-emitting elements 482 arranged circumferentially around the center of the substrate 481. The one or more light-receiving elements 483 may not be disposed on a virtual extension line connecting adjacent light-emitting elements 482. In an embodiment not shown, the light-receiving element 483 may be disposed at the center of the substrate 481. In an embodiment not shown, the one or more light-receiving elements 483 may be arranged circumferentially (e.g., alternately, equally spaced, or in any configuration) around the center of the substrate 481 together with the light-emitting elements 482.

An aspect of the disclosure may provide an electronic device that supports various capturing environments or conditions.

An electronic device 101; 301; 400; 500; 500-1; 500-2; 700 may include a camera module 180; 380A, 380B, and an optical module 380C; 480; 580; 580-1; 580-2; 680; 680-1; 680-2; 780. The optical module 380C; 480; 580; 580-1; 580-2; 680; 680-1; 680-2; 780 may include a substrate 481, a plurality of light-emitting elements 482; 582; 682 disposed on the substrate 481, and a first light-receiving element 483; 583; 683 disposed on the substrate 481 and configured to operate independently from the plurality of light-emitting elements 482; 582; 682.

The electronic device 400 may include a hole H. The plurality of light-emitting elements 482 and the first light-receiving element 483 may be substantially aligned with the hole H.

The electronic device 400 may include a hole H. The first light-receiving element 483 may be disposed in a central area of the substrate 481 facing the hole H.

The optical module 480 may include a phosphor 484 disposed on at least one light-emitting element among the plurality of light-emitting elements 482.

The electronic device 500; 500-1 may include a stand-alone controller 530 configured to control the plurality of light-emitting elements 582 and the first light-receiving element 583.

The controller 530 may be disposed to be integrated into the optical module 580. The controller 530 may be disposed separately from the optical module 580-1.

The electronic device 500; 500-1 may include a processor 120 configured to communicate with the controller 530. The processor 120 may be configured to transmit a command to the controller 530 to drive at least one light-emitting element among the plurality of light-emitting elements 582 to a predetermined output level. The processor 120 may be configured to request information on the first light-receiving element 583 to the controller 530.

The controller 530 may include a channel CH1 configured to individually control the plurality of light-emitting elements 582. The controller 530 may include channels CH2 and CH3 configured to control respective subsets of the plurality of light-emitting elements 582.

The optical module 480 may include a first optical filter F; F1 disposed on the first light-receiving element 483; 483A. The optical module 480 may include a second light-receiving element 483; 483B and a second optical filter F; F2 disposed on the second light-receiving element 483; 483B. The first optical filter F; F1 and the second optical filter F; F2 may have different optical characteristics.

The electronic device 400 may include a plurality of optical elements 685, 686 respectively disposed on the plurality of light-emitting elements 682 and the first light-receiving element 683.

The electronic device 400 may include an optical element 685-1, 686-1 disposed on at least one element among the plurality of light-emitting elements 682 and the first light-receiving element 683. The at least one element may be disposed in an area on the substrate.

The electronic device 400 may include an optical element 687 disposed on the plurality of light-emitting elements 682 and the first light-receiving element 683.

The electronic device 400 may include a hole H and an optical element L disposed in the hole H.

The plurality of light-emitting elements 482 may be disposed symmetrically. The optical module 480 may include the second light-receiving element 483. The first light-receiving element 483 and the second light-receiving element 483 may be disposed symmetrically.

The optical module 480 may include an array of the plurality of light-emitting elements 482. The first light-receiving element 483 may be disposed in a predetermined area within the array.

The plurality of light-emitting elements 482 may be arranged in a first direction and a second direction of the substrate 481. The first direction may be different from the second direction.

Two or more of the plurality of light-emitting elements 482 may be arranged in a circumferential direction around a center of the substrate. At least one of the plurality of light-emitting elements 482 may be disposed at the center of the substrate 481.

The first light-receiving element 483 may be disposed closer to the center of the substrate 481 than at least a portion of the light-emitting elements among the plurality of light-emitting elements 482.

An area of the plurality of light-emitting elements 482 may be greater than an area of the first light-receiving element 483.

A light-emitting element among the plurality of light-emitting elements 482 may be configured to emit light of a wavelength band different from a wavelength band of light emitted by another light-emitting element. A light-emitting element among the plurality of light-emitting elements 482 may have an illumination angle different from an illumination angle of another light-emitting element 482.

According to an embodiment, an ambient light sensing function such as a flicker sensor or a light sensor may be implemented in the optical module. According to an embodiment, a light-emitting area may be adjusted in the optical module. According to an embodiment, different light sources may be implemented for different conditions. According to an embodiment, a single integrated optical module may be provided. According to an embodiment, the degree of design freedom may be increased with respect to the optical module. According to an embodiment, external visibility and/or aesthetics may be improved. The effects of the electronic device according to embodiments are not limited to the above-mentioned effects, and other unmentioned effects may be clearly understood from the description of the disclosure by one of ordinary skill in the art.

The embodiments of the disclosure are intended to be illustrative and not restrictive. Various modifications may be made to the detailed description of the disclosure including the accompanying scope of claims and equivalents. Any of the embodiment(s) described herein may be used in combination with any other embodiment(s) described herein.

## Claims

1. An electronic device (101; 301; 400; 500; 500-1; 500-2; 700), comprising:
a camera module (180; 380A, 380B), and
an optical module (380C; 480; 580; 580-1; 580-2; 680; 680-1; 680-2; 780),
wherein the optical module (380C; 480; 580; 580-1; 580-2; 680; 680-1; 680-2; 780) comprises:
a substrate (481),
a plurality of light-emitting elements (482; 582; 682) disposed on the substrate (481), and
a first light-receiving element (483; 583; 683) disposed on the substrate (481) and configured to operate independently from the plurality of light-emitting elements (482; 582; 682).

2. The electronic device of claim 1, further comprising a hole (H),
wherein the plurality of light-emitting elements (482; 582; 682) and the first light-receiving element (483) are substantially aligned with the hole (H).

3. The electronic device of claims 1 or 2, further comprising a hole (H), wherein the first light-receiving element (483) is disposed in a central area of the substrate (481) facing the hole (H).

4. The electronic device of any one of claims 1 to 3, wherein the optical module (480) further comprises a phosphor (484) disposed on at least one light-emitting element among the plurality of light-emitting elements (482).

5. The electronic device of any one of claims 1 to 4, further comprising a stand-alone controller (530) configured to control the plurality of light-emitting elements (582) and the first light-receiving element (583),
optionally, wherein the controller (530) is disposed to be integrated into the optical module (580) or disposed separately from the optical module (580-1), or
optionally, wherein the electronic device further comprises a processor (120) configured to communicate with the controller (530),
wherein the processor (120) is configured to:
transmit a command to the controller (530) to drive at least one light-emitting element among the plurality of light-emitting elements (582) to a specified output level, and/or
request information on the first light-receiving element (583) to the controller (530),
optionally, wherein the controller (530) comprises:
a channel (CH1) configured to individually control the plurality of light-emitting elements (582), and/or
a channel (CH2, CH3) configured to control respective subsets of the plurality of light-emitting elements (582).

6. The electronic device of any one of claims 1 to 5, wherein the optical module (480) further comprises a first optical filter (F; F1) disposed on the first light-receiving element (483; 483A), wherein optionally, the optical module (480) further comprises a second light-receiving element (483; 483B) and a second optical filter (F; F2) disposed on the second light-receiving element (483; 483B), and the first optical filter (F; F1) and the second optical filter (F; F2) have different optical characteristics.

7. The electronic device of any one of claims 1 to 6, further comprising a plurality of optical elements (685, 686) respectively disposed on the plurality of light-emitting elements (682) and the first light-receiving element (683).

8. The electronic device of any one of claims 1 to 7, further comprising an optical element (685-1, 686-1) disposed on at least one element among the plurality of light-emitting elements (682) and the first light-receiving element (683), wherein the at least one element is disposed in an area on the substrate.

9. The electronic device of any one of claims 1 to 8, further comprising an optical element (687) disposed on the plurality of light-emitting elements (682) and the first light-receiving element (683).

10. The electronic device of any one of claims 1 to 9, further comprising a hole (H) and an optical element (L) disposed in the hole (H).

11. The electronic device of any one of claims 1 to 10, wherein the plurality of light-emitting elements (482) are disposed symmetrically, and/or
wherein the optical module (480) further comprises a second light-receiving element (483), and the first light-receiving element (483) and the second light-receiving element (483) are disposed symmetrically.

12. The electronic device of any one of claims 1 to 11, wherein the optical module (480) further comprises an array of the plurality of light-emitting elements (482), and the first light-receiving element (483) is disposed in a specified area within the array,
optionally, wherein the plurality of light-emitting elements (482) are arranged in a first direction and a second direction of the substrate (481), the first direction being different from the second direction, or
optionally, wherein two or more of the plurality of light-emitting elements (482) are arranged in a circumferential direction around a center of the substrate, and optionally, at least one of the plurality of light-emitting elements (482) is disposed at the center of the substrate (481).

13. The electronic device of any one of claims 1 to 12, wherein the first light-receiving element (483) is disposed closer to the center of the substrate (481) than at least a portion of light-emitting elements among the plurality of light-emitting elements (482).

14. The electronic device of any one of claims 1 to 13, wherein an area of the plurality of light-emitting elements (482) is greater than an area of the first light-receiving element (483).

15. The electronic device of any one of claims 1 to 14, wherein a light-emitting element among the plurality of light-emitting elements (482) is configured to emit light of a wavelength band different from a wavelength band of light emitted by another light-emitting element, and/or
wherein a light-emitting element among the plurality of light-emitting elements (482) has an illumination angle different from an illumination angle of another light-emitting element (482).
